(19) Europäisches Patentamt
European Patent Office
Office européen des brevets

(11) **EP 1 630 962 A1**

(12) **EUROPEAN PATENT APPLICATION**
published in accordance with Art. 158(3) EPC

(43) Date of publication:
**01.03.2006 Bulletin 2006/09**

(51) Int Cl.:
*H03K 17/687* (1980.01)   *H03K 17/16* (1968.09)
*H03K 19/00* (1968.09)   *H02M 7/48* (1968.09)

(21) Application number: **04745555.5**

(22) Date of filing: **03.06.2004**

(86) International application number:
**PCT/JP2004/007699**

(87) International publication number:
**WO 2004/109919 (16.12.2004 Gazette 2004/51)**

(84) Designated Contracting States:
**DE FR GB**

(30) Priority: **05.06.2003 JP 2003161140**

(71) Applicant: **SEIKO EPSON CORPORATION**
**Shinjuku-ku,**
**Tokyo 163-0811 (JP)**

(72) Inventor: **TAKEUCHI, Kesatoshi**
**c/o Seiko Epson Corporation**
**Suwa-shi, Nagano 3928502 (JP)**

(74) Representative: **Hoffmann, Eckart**
**Patentanwalt,**
**Bahnhofstrasse 103**
**82166 Gräfelfing (DE)**

(54) **DIGITAL DIFFERENTIAL AMPLIFICATION CONTROL DEVICE**

(57)   A digital differential amplification control device includes: digital data generator for differential amplification control; differential controller for transmitting separately an A-phase signal which is a rectangular wave transmitted from the data generator, and a B-phase signal that is an inverted A-phase signal; and corrector for correcting at least one of the A-phase signal and the B-phase signal so that no cross point of the A-phase signal and the B-phase signal is present.

**FIG.7**

# Description

<u>BACKGROUND</u>

## 1. Technical Field

The present invention relates to a digital differential amplification control device, and more particularly to a digital drive control device improved so as to solve the problem of energy loss. This digital drive control device can be applied to a PWM drive device, a PWM display device and a digital transmission device (e.g. DVI).

## 2. Related Art

Differential amplification (differential transmission) is a transmission method for determining "0" or "1" by driving two signal lines and determining the voltage (potential difference) thereof, and which excels in noise resistance and enables faster transmission. An example of this differential amplification circuit is disclosed in JP-A-5-298886. This related art comprises a first differential amplification circuit for receiving complementary input data by a gate of a first conductive type MOS transistor and transmitting complementary internal data, and a second differential amplification circuit for receiving the complementary internal data by a gate of a second conductive type MOS transistor which is an opposite conductive type from the first conductive type, and transmitting complementary output data.

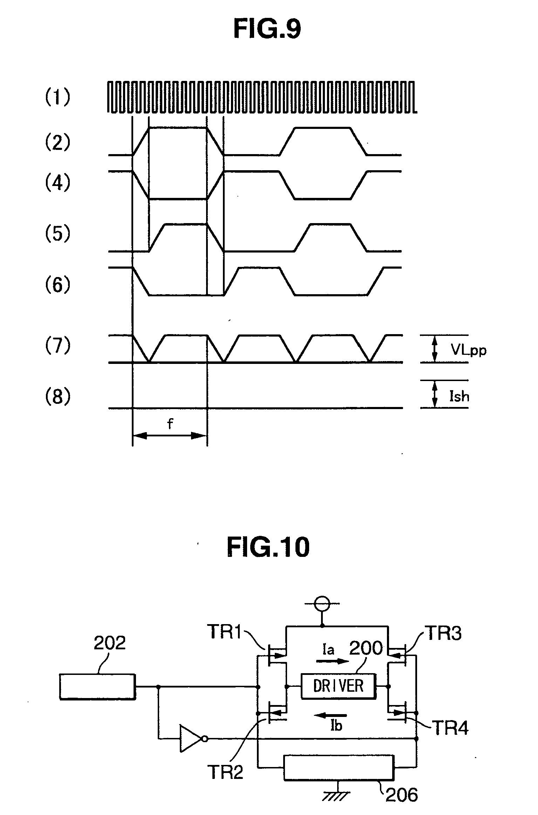

The differential amplification control is also applied to driving a load. Fig. 10 is a control device showing this, where the reference number 200 indicates a drive circuit section of the load which is driven by the drive control signal (A-phase signal) 202 of the load. The drive control signal 202 has a rectangular wave. The reference number 204 is an inverter (differential driver) for outputting a B-phase signal as an inverted A-phase signal to the load drive circuit. This differential amplification control circuit includes the switching transistors TR1 to TR4, used when the drive current is applied to a load.

If a high-level voltage is applied to the circuit as the A-phase signal 202, TR1 turns OFF, TR2 turns ON, TR3 turns ON and TR4 turns OFF, and the drive current having the Ib direction is applied to the driver 200 of the load.

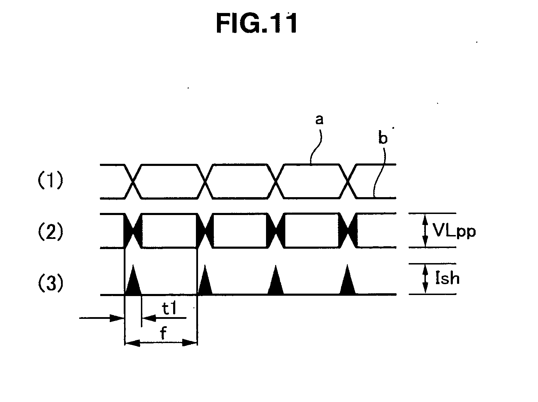

If a low-level voltage is applied to the circuit as the A-phase signal, TR1 turns ON, TR2 turns OFF, TR3 turns OFF and TR4 turns ON, and the current having the Ia direction, which is the opposite of Ib, is applied to the driver of the load. Fig. 11 shows the waveform diagram in this case, where (1) is a differential control waveform comprised of the A-phase signal and the B-phase signal, and the rectangular wave signal a of the A-phase and the rectangular wave signal b of the B-phase change the respective pattern alternately.

<u>SUMMARY</u>

A problem of digital differential amplification is that a short circuit occurs at the switching point of the positive side (A-phase signal) and the negative side (B-phase signal) by an active element. As Fig. 11 (2) and (3) show, at a cross point of the A-phase signal and the B-phase signal (a section filled in black: period tL in (3)), a loss due to the short circuit current Ish is generated because of the energy voltage loss VLpp. Therefore in the circuit in Fig. 10, a circuit 206, for protecting the active element (switching transistor) from the short circuit current Ish, is disposed. The loss of power is generated by this short circuit current and loss voltage. This loss of power is calculated as follows.

$$Psh = f * VLpp * Ish * (tL/2)\ \ unit: W.$$

For such a loss, no special consideration has been made in the communication field since speed for data transmission is demanded, and in the drive control field using PWM control, a current limiting circuit is disposed for protecting the drive element since the load power capacity is large. In other words, countermeasures against this loss are insufficient in terms of energy efficiency improvement as well.

An advantage of some aspects of the invention is to provide a digital differential amplification control device which excels in energy efficiency because of decreasing such loss, and which does not require a protective circuit for an active element.

To gain the above advantage, a digital differential amplification control device according to an aspect of the invention comprises digital data generator for differential amplification control, differential controller for transmitting an A-phase signal which is a rectangular wave transmitted from the data transmitter , separately from a B-phase signal as an inverted A-phase signal, and corrector for correcting at least one of the A-phase signal and the B-phase signal so that no cross point between the A-phase signal and the B-phase signal is present. According to an aspect of the invention, the cross points of a plurality of signals are masked in the differential control waveform, so the above mentioned problem of loss can be solved.

In the present embodiment, the differential amplification control device further comprises a load drive circuit, characterized in that the corrector outputs the A-phase signal and the B-phase signal to the drive circuit. The digital data generator for differential amplification control generates a drive control signal for the load, and outputs this signal to the drive circuit as digital data. The device further comprises differential receiver for receiving the A-phase signal and the B-phase signal, and outputting the digital data restored from both of these signals. The corrector masks at least one of the A-phase signal and the B-phase signal so that the cross point is not present. The corrector corrects at least one of the A-phase signal and the B-phase signal so that the cross point is not present based on the clock signal. And the corrector masks at least one side of a rising edge and a falling edge of at least one of the A-phase signal and the B-phase signal.

BRIEF DESCRIPTION OF THE DRAWINGS

Fig. 1 is a diagram depicting a motor as a load to be the differential amplification control target and the operation principle thereof.
Fig. 2 is a diagram depicting the operation principle continuing from Fig. 1;
Fig. 3 is a diagram depicting the operation principle continuing from Fig. 2;
Fig. 4 is a diagram depicting the operation principle continuing from Fig. 3;
Fig. 5 are equivalent circuit diagrams depicting the connection status of an electromagnetic coil;
Fig. 6(1) is a perspective view depicting a motor, Fig. 6(2) is a plan view depicting a rotor, Fig. 6(3) is a side view thereof, Fig. 6(4) is a side view depicting an A-phase electromagnetic coil (first magnetic body), and Fig. 6(5) is a side view depicting a B-phase electromagnetic coil (second magnetic body);
Fig. 7 is a block diagram depicting the control of the differential amplification control device according to an aspect of the invention;
Fig. 8 is a circuit block diagram thereof;
Fig. 9 are control waveform diagrams thereof;
Fig. 10 is a block diagram depicting a previous digital differential amplification control device; and
Fig. 11 are control waveform characteristic diagrams thereof.

DESCRIPTION OF EXEMPLARY EMBODIMENTS

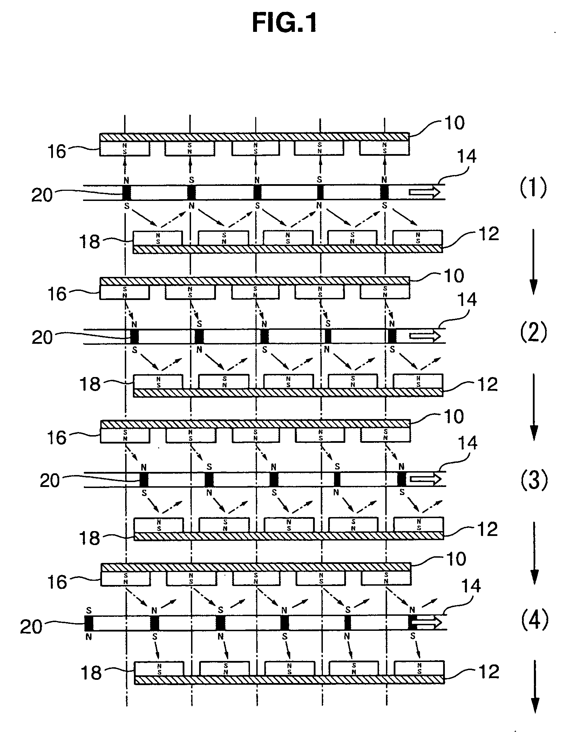

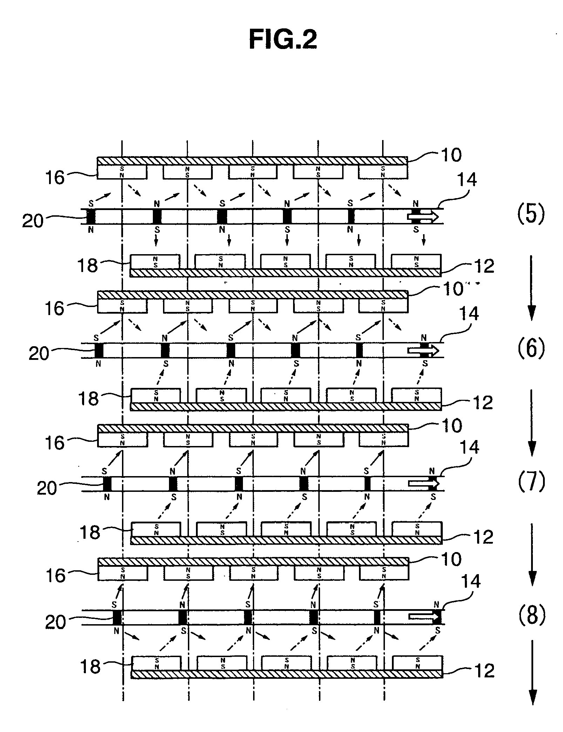

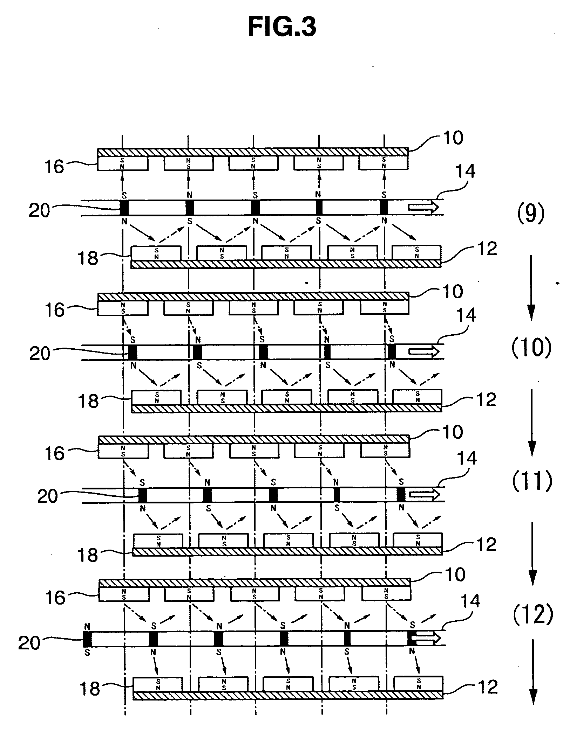

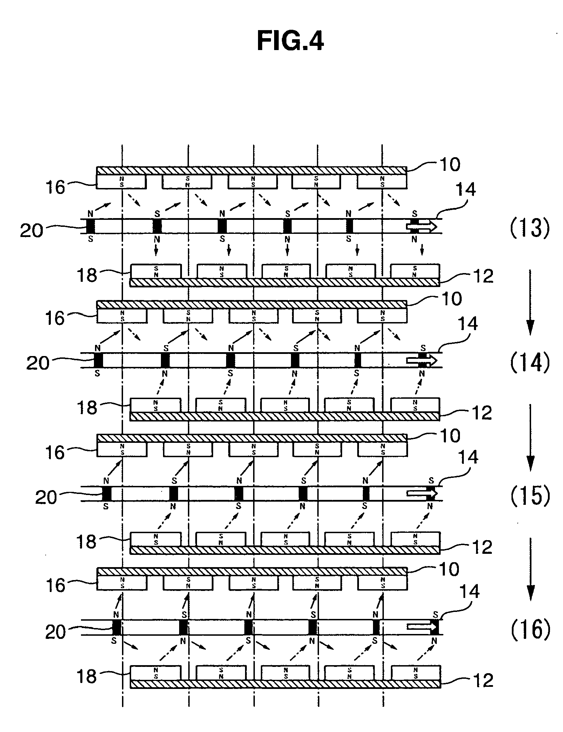

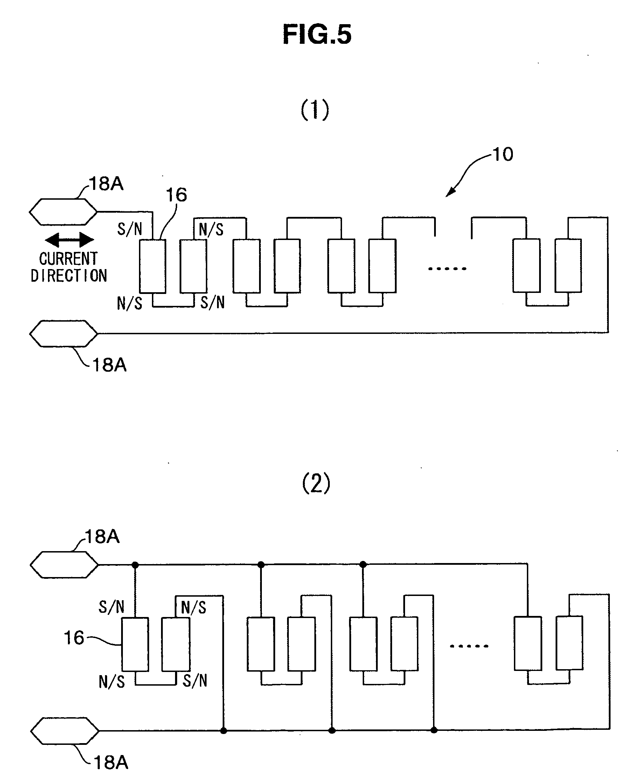

Embodiments of the invention will now be described. First an example of the load to be the target of differential amplification control will be described with reference to Fig. 1 to Fig. 4. Fig. 1 to Fig. 4 are diagrams depicting a motor to be the load in the invention, and the rotation principle thereof. This motor comprises a first magnetic body (first phase coil) 10 and a second magnetic body (second phase coil) 12, and a third magnetic body (permanent magnet) 14 which is disposed there between.
The configuration of these magnetic bodies may be annular (arched, circular) or linear. If the magnetic bodies are formed circular, the third magnetic body or one of the first and second magnetic bodies functions as a rotor, and if the magnetic bodies are formed linear, one of them becomes a slider.
In the first magnetic body 10, coils 16, which can excite alternately into an opposite polarity, are sequentially arrayed at predetermined spacing, preferably at equal spacing. Fig. 5 shows an equivalent circuit of the first magnetic body. According to Fig. 1 to Fig. 4, all of the coils, of the two-phase exciting coils, are always excited in the above mentioned polarity during starting rotation (2π). Therefore the driving target, such as the rotor or slider, can be rotated and driven at high torque.
As Fig. 5 (1) shows, a plurality of electromagnetic coils 16 (magnetic units) are connected in series at equal spacing. The reference symbol 18A indicates a block of an exciting circuit (drive circuit of the load) to apply frequency pulse signals on these magnetic coils. Each coil is preset to be excited so that the direction of the magnetic pole changes alternately between the adjacent coils when an exciting signal, for exciting the coils, is output from this exciting circuit to the electromagnetic coils 16. As Fig. 5 (2) shows, the electromagnetic coils 16 may be connected in parallel.
If signals, having a frequency to alternately switch the direction of poles of the exciting current to be supplied at a predetermined cycle, are applied from this exciting circuit 18A to the electromagnetic coils 16 of the first magnetic body 10 and the exciting coils 18 of the second magnetic body 12, a magnetic pattern, where the polarity at the third magnetic body side changes alternately as N → S → N, as shown in Fig. 1 to Fig. 4, is generated. If the polarity of the frequency pulse signal is reversed, a magnetic pattern, where the polarity of the first magnetic body at the third magnetic body side changes alternately as S → N → S, is generated. As a result, the exciting pattern which is generated in the first magnetic body 10 changes cyclically.
The structure of the second magnetic body 12 is similar to the first magnetic body 10, but the difference is that the electromagnetic coils 18 of the second magnetic body are arrayed deviated in position with respect to the electromagnetic coils 16 of the first magnetic body. In other words, the array pitch of the first magnetic body and the array pitch of the second magnetic body are set with a predetermined pitch difference (angle difference). This pitch difference is preferably a distance in which the permanent magnets (third magnetic body) 14 move from the coils 16 and 18 during one cycle (2π) of the frequency of the exciting current, in other words, the distance corresponding to 1/4 of the total distance of the pair of the N pole and S pole, that is π/2.
Now the third magnetic body 14 will be described. As Fig. 1 to Fig. 4 show, the third magnetic body 14 is disposed between the first magnetic body and the second magnetic body, and a plurality of permanent magnets 20 (filled in black) having alternate opposite polarities are arrayed in a line (in a straight line or an arc) at predetermined spacing, preferably at equal spacing. An arc includes a closed loop, such as a complete circle and an ellipse, as well as an unspecified circular structure, semi-circle and fan-shape.
The first magnetic body 10 and the second magnetic body 12 are disposed in parallel at an equal distance, and the third magnetic body 14 is disposed at the center position of the first magnetic body 10 and the second magnetic body 12. In the third magnetic body, the array pitch of an individual permanent magnetic is largely the same as the array pitch of the magnetic coils of the first magnetic body 10 and the second magnetic body 12.

Now the operation of the magnetic body structure where the above mentioned third magnetic body 14 is disposed between the first magnetic body 10 and the second magnetic body 12 will be described with reference to Fig. 1 to Fig. 4. By the above mentioned exciting circuit (18 in Fig. 5), the excitation pattern shown in (1) of Fig. 1 is generated in the electromagnetic coils 16 and 18 of the first magnetic body and the second magnetic body at a certain instant. At this time, in each coil 16 on the surface of the first magnetic body 10 facing the third magnetic body 14 side, magnetic poles are generated according to the pattern S → N → S → N → S, and in the coil 18 on the surface of the second magnetic body 12 facing the third magnetic body 14 side, magnetic poles are generated according to the pattern N → S → N → S → N. The solid line arrow marks in the drawings indicate the attraction force, and the dashed line arrow marks indicate the reaction force.

At the next instant, when the polarity of the pulse wave, which is applied to the first magnetic body via the drive circuit 18 (Fig. 5), is inverted as shown in (2), a repulsion is generated between the magnetic pole generated in the coils 16 of the first magnetic body 10 in (1) and the magnetic pole of the permanent magnets 20 on the surface of the third magnetic body 14, and an attraction is generated between the magnetic pole generated on the coils 18 of the second magnetic body 12 and the magnetic pole on the surface of the permanent magnets of the third magnetic body 14, therefore as (1) to (5) show, the third magnetic body moves sequentially in the right direction in the drawings.

A pulse wave, of which phase is shifted from the exciting current of the first magnetic body, is applied to the coils 18 of the second magnetic body 12, and as shown in (6) to (8), the magnetic pole of the coils 18 of the second magnetic body 12 and the magnetic pole on the surface of the permanent magnets 20 of the third magnetic body 14 repel each other, and the third magnetic body 14 is moved further to the right direction. (1) to (8) show the case when the permanent magnets have moved for a distance corresponding to $\pi$, and (9) to (16) show the case when the permanent magnets have moved a distance corresponding to the remaining $\pi$, that is when the third magnetic body has moved relatively from the first and second magnetic bodies for a distance corresponding to one cycle ($2\pi$) of the frequency signal, which is supplied to the electromagnetic coils 16 and 18 in (1) to (16).

In this way, by supplying frequency signals, of which phases are different from each other, to the first magnetic body (A-phase) and the second magnetic body (B-phase) respectively, the third magnetic body 14 can slide linearly, or the third magnetic body 14 can rotate as a rotor.

If the first magnetic body, second magnetic body and third magnetic body are lined up in an arc shape, this magnetic structure shown in Fig. 1 constitutes the rotary motor, and if these magnetic bodies are lined up in a linear shape, then this magnetic structure constitutes the linear motor. In other words, by the structure of these magnetic bodies, a rotary drive, such as a motor, can be implemented.

According to this magnetic structure, the third magnetic body can be moved by the magnetic force received from the first magnetic body and the second magnetic body, so the torque for moving the third magnetic body increases and the torque/weight balance improves, therefore a compact motor, that can be driven at high torque, can be provided.

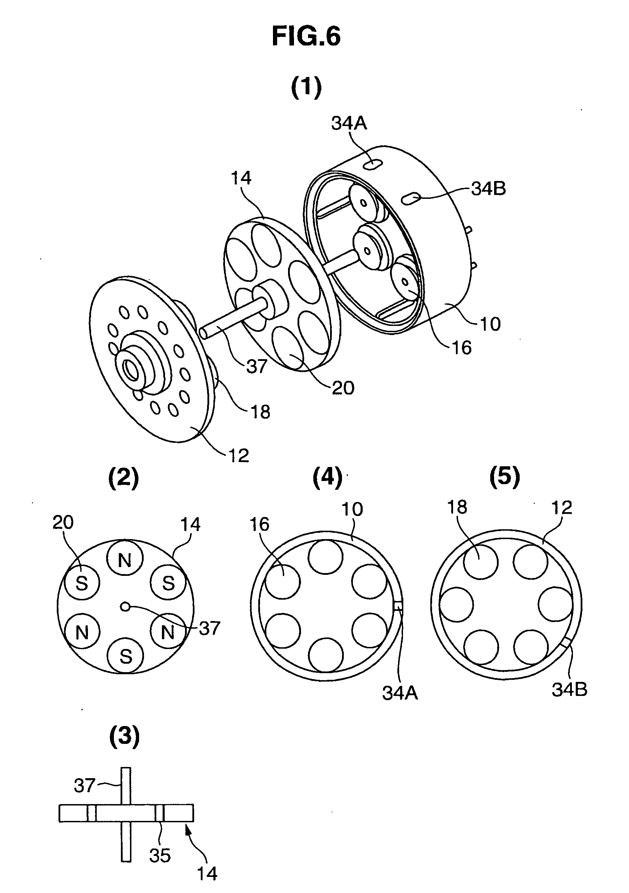

Fig. 6 shows the above mentioned magnetic body structure embodied as a synchronous motor, where Fig. 6(1) is a perspective view of this motor, Fig. 6(2) is a plan view of the rotor (third magnetic body), Fig. 6(3) is a side view thereof, Fig. 6(4) is an A-phase electromagnetic coil (first magnetic body), and Fig. 6(5) is a B-phase electromagnetic coil (second magnetic body). The composing element in Fig. 6, the same as that in the above mentioned drawings, is denoted with the same reference symbol.

This motor comprises a pair of first phase magnetic body 10 and second phase magnetic body 12, which corresponds to a stator, and the above mentioned third magnetic body 14 constituting a rotor, and the rotor 14 is rotatably disposed with the axis 37 at the center between the first phase magnetic body and the second phase magnetic body. The rotation axis 37 is press-fit in the hole for the rotation axis, which exists at the center of the rotor so that the rotor and the rotation axis rotate together. As Figs. 6(2), (4), and (5) show, six permanent magnets 20 are disposed on the rotor at equal spacing in the circumference direction, where the polarity of the permanent magnets are alternately opposite, and six electromagnetic coils are disposed on the stator at equal spacing in the circumference direction.

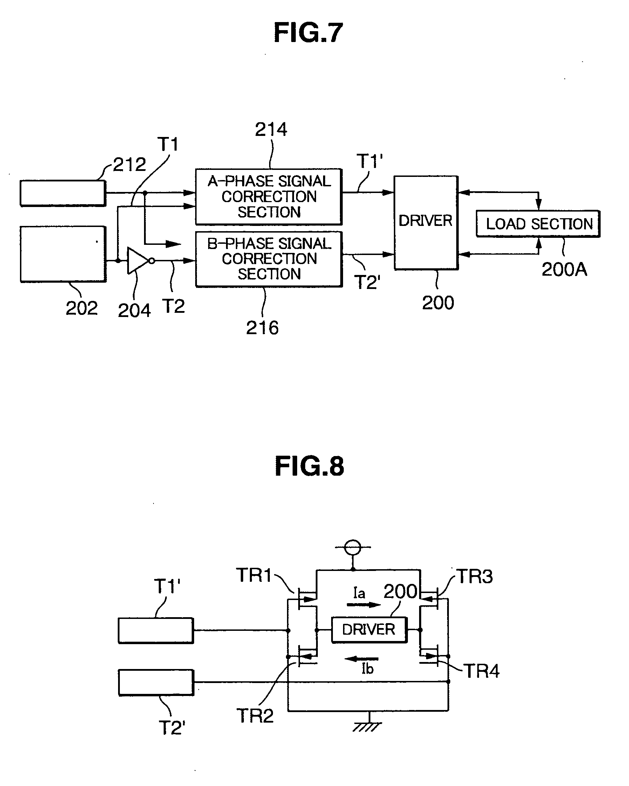

The above mentioned drive circuit is disposed in the first phase coil and the second phase coil respectively, and two-phase signals, A-phase and B-phase, are supplied to each drive circuit. Fig. 7 is a block diagram depicting the control of the differential amplification control device according to an aspect of the invention, Fig. 8 is a circuit diagram of the driver 200, and Fig. 9 depicts control waveform diagrams thereof. The differences from a previous configuration are that the A-phase signal correction section 214 and the B-phase signal correction section 216, for correcting the A-phase signal and the B-phase signal, are disposed so that the cross points of the A-phase signal and the B-phase signal are removed, and that the clock signal generation section 212 for this correction is included. T1 is an A-phase control signal before the correction, T1' is an A-phase control signal after the correction, T2 is a B-phase control signal before the correction, and T2' is a B-phase control signal after the correction. 200A is a load, and is a first phase coil or a second phase coil of the above mentioned motor. The two-phase control signals, A and B, are supplied to the drive control circuit 200 of the coil of each phase.

In Fig. 9, (1) is an output waveform diagram for the clock signal for correction, (2) is an output waveform of the A-phase signal before the correction, and (3) is an output waveform of the B-phase signal before the correction. The output waveform before the correction is generated and is output in the differential amplification control signal generation section 202. The correction sections 214 and 216 correct each phase signal based on the clock signal for the correction.

(4) is an A-phase signal after the correction, and as the comparison with the signal before the correction shows, the A-phase signal correction section 214 masks the rise of the A-phase signal before the correction for two pulses of the correction clock. This is the same for the correction section 216 for the B-phase signal. (5) is the B-phase signal waveform pattern after the correction.

As (6) shows, the cross points of each phase signal are masked at the point of the pole switching of the A-phase/B-phase after the correction, so neither a voltage loss nor a current loss is generated (7). Therefore in Fig. 8, the short circuit current protective circuit can be omitted.

In the above description, the differential amplification control signal generation section 212 in Fig. 7 corresponds to the digital data generator for differential amplification control in the Claims, and the inverter (differential driver) 204 corresponds to the differential amplifier, and 214 and 216 correspond to the corrector.

As described above, in the invention, the differential amplification control is used for driving the load, but if the load is regarded as impedance in the data transmission section, the invention can also be applied to data transmission.

As described above, according to an aspect of the invention, the invention can provide a digital differential control device which excels in low power consumption and energy efficiency by decreasing the loss, and makes a protective circuit for an active element unnecessary. Also the invention can decrease the radiation noise by eliminating a waste of energy, and the consumption efficiency of batteries can be improved for the use of portable equipment and eco-automobiles.

**Claims**

1. A digital differential amplification control device, comprising:

   digital data generator for differential amplification control;
   differential controller for transmitting separately an A-phase signal which is a rectangular wave transmitted from the data generator, and a B-phase signal that is an inverted A-phase signal; and
   corrector for correcting at least one of the A-phase signal and the B-phase signal so that no cross point of the A-phase signal and the B-phase signal is present.

2. The device according to Claim 1, further comprising a load drive circuit, wherein the corrector outputs the A-phase signal and the B-phase signal to the drive circuit.

3. The device according to Claim 2, wherein the digital data generator for differential amplification control generates a drive control signal for the load and supplies the drive control signal as digital data to the drive circuit.

4. The device according to Claim 1, further comprising differential receiver for receiving the A-phase signal and the B-phase signal, and outputting the digital data restored from both of these signals.

5. The device according to Claim 1, wherein the corrector masks at least one of the A-phase signal and the B-phase signal so that the cross point is not present.

6. The device according to Claim 5, wherein the corrector masks at least one side of a rising edge and a falling edge of at least one of the A-phase signal and the B-phase signal.

**Amended claims in accordance with Rule 86(2) EPC.**

1. After amendment)
   A digital differential amplification control device, comprising:

   digital data generator for differential amplification control;
   differential controller for transmitting separately an A-phase signal which is a rectangular wave transmitted from the data generator, and a B-phase signal that is an inverted A-phase signal; and
   corrector for generating a corrected waveform of at least one of the A-phase signal and the B-phase signal based on a clock signal for correction so that no cross point of the A-phase signal and the B-phase signal is present.

2. The device according to Claim 1, further comprising a load drive circuit, wherein the corrector outputs the A-phase signal and the B-phase signal to the drive circuit.

**3.** The device according to Claim 2, wherein the digital data generator for differential amplification control generates a drive control signal for the load and supplies the drive control signal as digital data to the drive circuit.

**4.** The device according to Claim 1, further comprising differential receiver for receiving the A-phase signal and the B-phase signal, and outputting the digital data restored from both of these signals.

**5.** The device according to Claim 1, wherein the corrector masks at least one of the A-phase signal and the B-phase signal so that the cross point is not present.

**6.** The device according to Claim 5, wherein the corrector masks at least one side of a rising edge and a falling edge of at least one of the A-phase signal and the B-phase signal.

# FIG.1

# FIG.2

# FIG.3

# FIG.4

# FIG.5

(1)

(2)

# FIG.6

## (1)

## (2)

## (4)

## (5)

## (3)

EP 1 630 962 A1

# FIG.7

# FIG.8

# FIG.9

(1)

(2)

(4)

(5)

(6)

(7)    $VL_{pp}$

(8)    $I_{sh}$

f

# FIG.10

202

TR1    $I_a$    200    TR3

DRIVER

$I_b$    TR4

TR2    206

# FIG.11

## INTERNATIONAL SEARCH REPORT

| International application No. |
| --- |
| PCT/JP2004/007699 |

**A. CLASSIFICATION OF SUBJECT MATTER**
Int.Cl⁷ H03K17/687, 17/16, 19/00, H02M7/48

According to International Patent Classification (IPC) or to both national classification and IPC

**B. FIELDS SEARCHED**

Minimum documentation searched (classification system followed by classification symbols)
Int.Cl⁷ H03K17/00-17/70, 19/00, H02M7/48, 7/537

Documentation searched other than minimum documentation to the extent that such documents are included in the fields searched
Jitsuyo Shinan Koho          1922-1996   Toroku Jitsuyo Shinan Koho   1994-2004
Kokai Jitsuyo Shinan Koho   1971-2004   Jitsuyo Shinan Toroku Koho   1996-2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 08-266070 A  (Kabushiki Kaisha T.I.C. -CITIZEN), 11 October, 1996 (11.10.96), Par. Nos. [0008] to [0024]; Figs. 1, 2 (Family: none) | 1-6 |
| X | JP 08-307230 A  (Canon Inc.), 22 November, 1996 (22.11.96), Par. Nos. [0021] to [0034]; Figs. 1 to 3 (Family: none) | 1-6 |
| X | JP 10-013207 A  (Fujitsu Ltd.), 16 January, 1998 (16.01.98), Par. Nos. [0020] to [0043]; Figs. 2 to 4 (Family: none) | 1-6 |

| ☒ | Further documents are listed in the continuation of Box C. | ☐ | See patent family annex. |
| --- | --- | --- | --- |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| 28 June, 2004 (28.06.04) | 20 July, 2004 (20.07.04) |

| Name and mailing address of the ISA/ Japanese Patent Office | Authorized officer |
| --- | --- |
| Facsimile No. | Telephone No. |

Form PCT/ISA/210 (second sheet) (January 2004)

**INTERNATIONAL SEARCH REPORT**

International application No.

PCT/JP2004/007699

C (Continuation). DOCUMENTS CONSIDERED TO BE RELEVANT

| Category* | Citation of document, with indication, where appropriate, of the relevant passages | Relevant to claim No. |
|---|---|---|
| E,X | JP 2003-189683 A (Denso Corp.), 04 July, 2003 (04.07.03), Par. Nos. [0028] to [0064]; Figs. 2, 3 (Family: none) | 1-6 |
| E,X | JP 2003-133953 A (Sharp Corp.), 09 May, 2003 (09.05.03), Par. Nos. [0036] to [0083]; Figs. 1 to 3 (Family: none) | 1-6 |
| A | JP 05-298886 A (Matsushita Electric Industrial Co., Ltd.), 12 November, 1993 (12.11.93), Par. Nos. [0010] to [0017]; Figs. 1, 2 (Family: none) | 1-6 |
| A | JP 2000-031810 A (Fujitsu Ltd.), 28 January, 2000 (28.01.00), Par. Nos. [0014] to [0017]; Figs. 1, 2 & US 2000/40466 A1 | 1-6 |

Form PCT/ISA/210 (continuation of second sheet) (January 2004)